Europäisches Patentamt

European Patent Office

Office européen des brevets

(11) Publication number: **0 077 818**
**B1**

(12) **EUROPEAN PATENT SPECIFICATION**

(45) Date of publication of patent specification: **22.02.89**

(51) Int. Cl.⁴: **H 01 L 23/48,** H 01 L 23/02,
H 01 L 39/02, H 01 L 23/12

(21) Application number: **82901705.2**

(22) Date of filing: **26.04.82**

(86) International application number:
**PCT/US82/00530**

(87) International publication number:
**WO 82/03947 11.11.82 Gazette 82/27**

(54) **A PACAKAGE FOR A SEMICONDUCTOR CHIP HAVING A CAPACITOR AS AN INTEGRAL PART THEREOF.**

(30) Priority: **06.05.81 US 261037**

(43) Date of publication of application:
**04.05.83 Bulletin 83/18**

(45) Publication of the grant of the patent:
**22.02.89 Bulletin 89/08**

(84) Designated Contracting States:
**DE FR**

(56) References cited:
**FR-A-2 456 388**
**GB-A-1 245 710**
**US-A-3 268 778**
**US-A-3 535 486**
**US-A-3 554 821**
**US-A-3 713 006**
**US-A-3 728 589**
**US-A-3 969 752**
**US-A-3 999 142**
**US-A-4 234 666**
**US-A-4 249 196**

(73) Proprietor: **Western Electric Company,
Incorporated
222 Broadway
New York, NY 10038 (US)**

(72) Inventor: **SCHAPER, Leonard William
33 Lenox Terrace
West Orange, NJ 07052 (US)**

(74) Representative: **Johnston, Kenneth Graham
AT&T (UK) LTD. AT&T Intellectual Property
Division 5 Mornington Road
Woodford Green Essex, IG8 OTU (GB)**

Courier Press, Leamington Spa, England.

## Description

### Background of the Invention

This invention relates to semiconductor chips and, more particularly, to a package structure for housing and establishing electrical connections to such a chip.

Various designs for packaging semiconductor chips are known, such as U.K. Patent 1,245,710 discloses an arrangement for mounting a semi-conductor element within a recess in a ceramic case. The latter comprises a ceramic base plate including a plurality of parallel conductors constituting a capacitor which functions to decrease the power source inductance and suppress the spike current. Some of these designs provide adequate mechanical, environmental and thermal protection for the housed chip. But, with respect to establishing signal and power connections to the chip, these package designs typically treat signal interconnection and power distribution to the chip as being basically the same. As a result of this standard design approach, conventional packages suffer from the disadvantage that the power supplied to the chip may include undesirable switching transients. This is particularly true if relatively large currents must be switched and delivered to the chip in a high-speed manner. In such cases, the presence of even small inductances in the power supply distribution network, even within the chip package, can generate significant spurious voltage signals. Such signals can, of course, deleteriously affect the performance of the chip.

To minimize the impedance, especially the inductance, of the distribution network that supplies power to the chip, it is standard practice in a conventional high-performance package design to utilize multiple ones of the package leads as power and ground connections. This approach tends to reduce inductance and thereby reduce the magnitude of spurious or transient signals that occur in the power distribution network. But one penalty of this approach is that a relatively large number of pins or leads of the package are thereby made unavailable for signal transfer purposes. In some cases, this may in turn necessitate redesign of the package to provide a physically larger unit with additional signal leads. Such a redesign, however, clearly runs counter to the desired goal, of making the packaged chips as small as possible.

Additionally, a separate by-pass capacitor element is often utilized in the distribution network that supplies power to an integrated circuit chip. Spurious noise signals arising from switching transients are shunted by the by-pass capacitor element and thereby kept from being applied to the chip. Moreover, the capacitor acts as a local reservoir of energy for current surges drawn by the chip. But, even if such a capacitor element is positioned physically close to its associated chip on a mounting board, inductance in the leads connecting the element to the chip can be the basis for generating significant spurious voltages in the connecting leads. These voltages are "seen" only at the chip itself. Moreover, the by-pass capacitors included in a microelectronic assembly can occupy a significant part of the available area on the mounting board. As the trend to smaller and smaller assemblies continues, it would obviously be desirable to reduce the board area occupied by by-pass capacitors.

Accordingly, considerable effort has been directed at trying to design improved packages for semiconductor chips. In particular, much effort has been directed at trying to provide small-size packaged chips exhibiting high-performance electrical characteristics.

According to the present invention there is provided a semi-conductor package comprising a semiconductor chip with conductive pads thereon, a body member defining an interior cavity, means for mounting the chips within the cavity, multiple signal paths having inner ends connected to respective ones of the pads on the chip and having outer ends that serve as signal terminal members, and the body member comprising spaced planar power members in parallel planes, characterised in that said planar members have outer peripheral portions on external walls of the body member, and inner peripheral portions on internal walls of the body member, the package comprising multiple link means connecting the inner peripheral portions of the planar members to selected ones of the pads on the chip, and a pair of power supply terminals members connected to the outer peripheral portions of respective ones of the power members.

In an embodiment of the present invention there is provided a packaged chip to which power is supplied in a substantially transient-free manner and to and from which signals are transferred in a particularly effective way. Moreover, there is provided a power supply by-pass capacitor for the chip in as compact and space-saving a manner as possible.

The embodiment provides a package for a semiconductor chip including planar power and ground members. Additionally, the package includes multiple signal leads extending therefrom. By means of the planar members, power is distributed to the chip from an external power supply. Significantly, this is done in a low-impedance substantially transient-free manner.

To minimize inductance, both of the planar power and ground members are designed to be as large in area as possible. Moreover, the planar members are formed in the package in closely spaced-apart parallel planes. Electrical connections extend from the planar members to a common interconnection level of the package.

Advantageously, the signal leads are separated from the ground plane of the package by a low-dielectric-constant material. As a result, the signal leads are minimally loaded and are characterized by a relatively constant impedance selected to optimize signal transfer to and from the chip.

A power supply by-pass capacitor element is advantageously included in the chip package as an integral part thereof.

More specifically, there is provided a frame-shaped capacitor element that constitutes an integral part of the package. The chip is mounted within a recess defined by the frame-shaped element. Conductive surface portions formed on the capacitor element serve as terminals of the element and as planar power and ground members for interconnecting an external power supply to the chip. Power supply terminal members connected to the planar members emanate from the package. Link members connect the power and ground members to the chip. Additionally, an insulating layer is formed on the planar ground member. Multiple signal leads extend from the package. These leads lie on the insulating layer and are connected to the chip.

Brief Description of the Drawings

A complete understanding of the present invention and of the above and other features thereof may be gained from a consideration of the following detailed description presented hereinbelow in connection with the accompanying drawings, in which:

FIG. 1 is a perspective view, partially broken away, of a specific illustrative semiconductor chip package made in accordance with the principles of the present invention;

FIG. 2 is a cross-sectional depiction at line 10 of FIG. 1 as viewed in the direction of arrow 2;

FIG. 3 is a cross-sectional representation at line 12 of FIG. 1 as viewed in the direction of arrow 3;

FIG. 4, which is a top view of the capacitor element included in FIG. 1, depicts side-metallized portions thereof;

FIG. 5 is a top view of the metallic pattern formed on top of the capacitor element;

FIG. 6 is a top view of an insulating layer formed on top of the metallic pattern of FIG. 5; and

FIG. 7 is a top view of the lead-frame and chip shown in FIG. 1.

Detailed Description

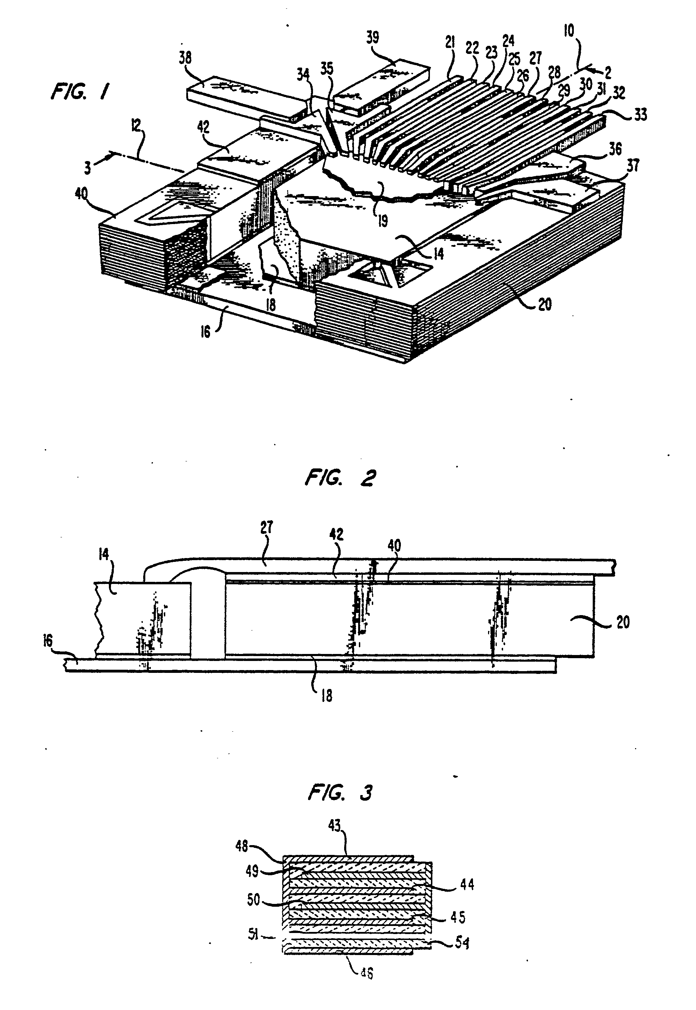

In FIG. 1, a conventional semiconductor chip 14 is shown mounted on a conductive plate 16 that constitutes the base member of a package for the chip. The plate 16, made, for example of aluminum, serves as a heat sink for the depicted assembly. By way of example, the chip comprises a standard high-speed very-large-scale-integrated circuit of the metal-oxide-semiconductor type. Illustratively, the bottom side of the chip 14 is bonded to the plate 16 by a layer 18 of conductive epoxy cement.

A frame-shaped element 20 surrounds the chip 14 of FIG. 1. The element 20 is also bonded to the plate 16 by means of the conductive epoxy cement layer 18. In one specific illustrative embodiment of the invention, the frame-shaped element 20, which serves as an integral part of the depicted package, comprises a by-pass capacitor.

In other embodiments of the principles of the present invention, the frame-shaped element 20 is not a capacitor but designed instead simply to be a part of the housing for the chip 14. The main emphasis herein will be directed to an embodiment in which the element 20 is a capacitor. In such an embodiment, which constitutes a particularly compact and advantageous version of applicant's invention, the closely spaced-apart plates of the capacitor itself constitute the parallel-plane-disposed power and ground members of applicant's low-inductance power distribution network.

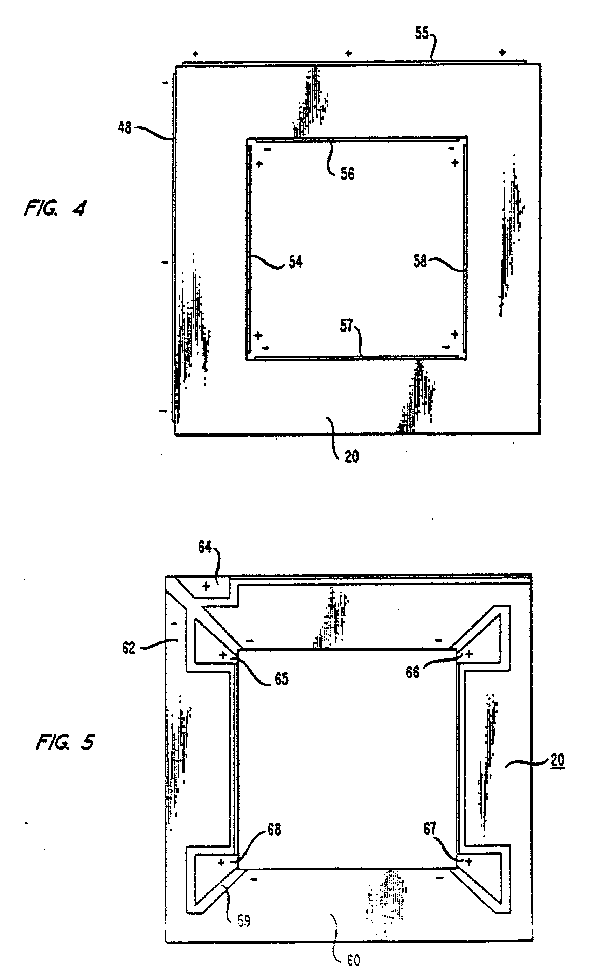

The capacitor element 20 of FIG. 1 is formed, for example, by punching a conventional multi-layer sheet of metallized layers of ceramic. Such multilayered ceramic sheets are known in the art and commercially available. Further details of the structure of the element 20 will be set forth below in connection with the description of FIG. 3.

Advantageously, multiple connections to the chip 14 are made thereto in a standard tape-automated-bonding operation before the chip is positioned within the package shown in FIG. 1. In that operation, multiple pads on the top of the chip are simultaneously connected to a conductive foil lead-frame, in a manner well known in the art. The lead-frame-supported chip 14 is then mounted in the depicted package. Subsequently, the lead-frame is trimmed. Additionally, a layer 19 of protective material, such as a standard roomtemperature-vulcanizing rubber, is advantageously applied to the top surface of the chip 14, as indicated in FIG. 1.

A portion of the trimmed lead-frame is shown in FIG. 1. The depicted portion comprises signal leads 21 through 33 whose free or outer ends extend beyond one outer edge of the package. The other or inner ends of these leads are respectively electrically connected to various points of the integrated circuit formed on the chip 14. Additionally, the depicted portion comprises link members 34 through 37. The inner ends of the members 34 through 37 are respectively connected to various power and ground pads on the chip 14. Outer regions of these link members are connected to planar power and ground members formed on surfaces of the capacitor element 20, as will be specified in detail later below.

Furthermore, in accordance with the principles of the present invention, the trimmed lead-frame shown in FIG. 1 also includes power and ground terminal members 38 and 39. The inner ends of these members 38, 39 are respectively connected to the planar power and ground line members 34, 35 formed on and within the capacitor element 20. The outer or free ends of the members 38 and 39 extend beyond outer edges of the package. These outer ends constitute terminal members for connecting the packaged chip to an external power supply.

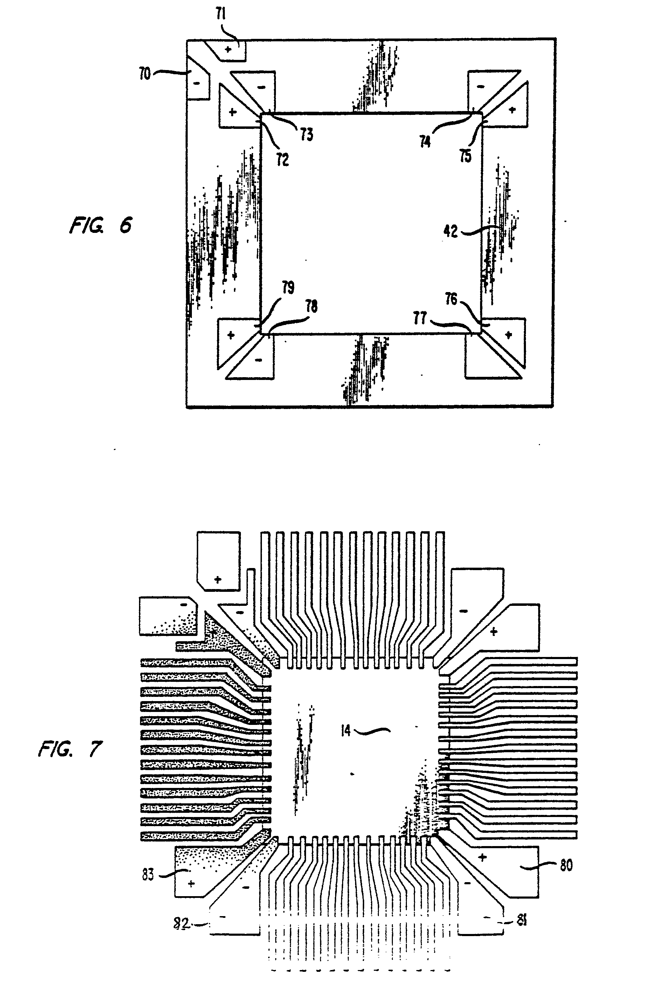

In FIG. 1, only one group of thirteen signal leads 21 through 33 extending beyond one edge of the package are explicitly shown. But it is to be understood that such a package typically includes three other identical groups of signal leads respectively extending beyond the other three edges of the package. Additionally, the package also typically includes two other pairs of link members respectively disposed adjacent to the other two inner corners of the capacitor element 20. (These other signal leads and link members will be specifically identified below in connection with the description of FIG. 7)

The upper most conductive plate 40 of the capacitor element 20 shown in FIG. 1 constitutes a planar ground member. An insulating layer 42 made, for example, of a polyimide material is deposited on top of the ground member 40. In turn, all of the signal leads (such as the leads 21 through 33) include portions that rest directly on top of the insulating layer 42. In one specific illustrative embodiment, in which the width of each signal lead is about 100 micrometers, the thickness of each signal lead is 50-to-100 micrometers and the thickness of the layer 42 is 50-to-100 micrometers, the characteristic impedance of the signal leads is thereby established at about 50-to-80 ohms.

FIG. 2 shows the conductive signal lead 27 of the packaged chip of FIG. 1. The lead 27 is disposed on the insulating layer 42 that overlies the planar ground member 40. As indicated above, the member 40 is the top conductive plate of the capacitor element 20. Portions of the chip 14, the conductive bonding layer 18 and the base plate 16 are also indicated in FIG. 2. If desired, a thin nonconductive bonding layer (not shown) may be interposed between the lead 27 and the insulating layer 42 to impart additional mechanical stability to the assembly. Alternatively, the dielectric layer 42 may itself be an adhesive material.

FIG. 3, which is a cross-sectional representation of the capacitor element 20, indicates the multilayered structure thereof. The element 20 comprises alternating layers of metal and ceramic. Metallic layers 43 through 46 are interconnected by side metallization 48. Top metallic layer 43 constitutes the ground plane 40 shown in FIG. 1. Accordingly, in this particular illustrative embodiment, the bottom metallic layer 46 that rests in contact with the base plate 16 (FIG. 1) is also intended to be grounded.

By means of power supply terminal member 38 (FIG. 1), the ground (or relatively negative) terminal of an external direct-current power supply is connected to the layers 43 through 46 and to the side metallization 48 shown in FIG. 3. The particular manner in which this is done within the package assembly will be specified in more detail below.

Metallic layers 49 through 51 shown in FIG. 3 are interconnected by side metallization 54. The side portion 54 is intended to be connected to the positive terminal of an external direct-current power supply. This is done by establishing an electrical connection within the package assembly between the metallization 54 and power supply terminal member 39, as will be specified in more detail below.

FIG. 3 shows two of the side metallizations formed on the capacitor element 20. These metallizations 48 and 54 are schematically represented in FIG. 4 and identified there with the same reference numerals utilized therefor in FIG. 3. Moreover, in FIG. 4, these metallizations 48 and 54 are designated with negative and positive signs to indicate to which respective terminals of the external power supply they are intended to be connected. Furthermore, in accordance with the principles of the present invention, additional similar side metallizations are formed on the element 20. These additional metallizations 55 through 58 are shown in FIG. 4 and are also marked with positive and negative signs to indicate their interconnection pattern.

It is evident from FIG. 4 that energy from an external power supply enters the capacitor element 20 at the outside edges of the element. Connections for the power supply are made to those edges by means of the terminal members 38 and 39 (FIG. 1). In turn, energy is delivered from the capacitor element to the associated chip along the inner edges of the element via short connections to the chip contained therein. In that way the inductances included in the input and output circuit paths connected to the capacitor element 20 are minimized.

FIG. 5 shows the metallization pattern printed or otherwise formed in a standard manner on the capacitor element 20 on top of the uppermost ceramic layer 59 thereof. A major part 60 of the pattern comprises the aforespecified ground plans (designated with a negative sign). The part 60 is electrically connected to the side metallizations 48, 56 and 57 represented in FIG. 4. Illustratively, the power supply terminal member 38 (FIG. 1) is designed to contact end portion 62 of the part 60.

Also formed on top of the uppermost ceramic layer 59 (FIG. 5) of the capacitor element 20 are conductive regions 64 through 68 (each marked with a positive sign). The region 64 is electrically connected to the side metallization 55 of FIG. 4; the regions 65 and 68 are connected to the side metallization 54 of FIG. 4; and the regions 66 and 67 are connected to the side metallization 58 of FIG. 4.

The power supply terminal member 39 (FIG. 1) is designed to contact the conductive region 64 of FIG. 5. In that way, the positive side of the external power supply is connected to the capacitor element 20.

As indicated in FIG. 5, each of the four inner corners of the metallization pattern formed on top of the capacitor element 20 includes positive and negative regions. By means of link members, interconnections are made beween these regions and conductive pads on the chip contained within the depicted framework. Four such link members designated 34 through 37 are shown in FIG. 1.

In the aforespecified illustrative embodiment, the link member pairs are shown at the corners of the chip. But it is to be understood that these link members may be located anywhere around the periphery of the inside edge of the capacitor element 20 if appropriate electrical connections to the positive (power) metallization are made by conductive patterns and/or conductive vias through the uppermost ceramic layer of the capacitor element.

FIG. 6 shows the pattern of the insulating layer 42 formed on top of the planar ground member 40 of FIG. 1. Openings 70 through 79 in the layer 42 provide access therethrough to selected portions of the underlying metallization pattern shown in FIG. 5. By means of conductive epoxy cement or by any other standard conductive attachment technique, electrical connections are established between the overlying lead-frame (FIG. 1) and the metallization portions directly underlying the openings 70 through 79.

FIG. 7 is a top view of the particular illustrative packaged chip of FIG. 1. All fifty-two signal leads connected to the chip 14 are explicitly shown in FIG. 7. Moreover, the previously specified power supply terminal members 38 and 39 and the link members 34 through 37 associated with two corners of the chip 14 are also shown in FIG. 7. Further, four additional link members 80 through 83 associated with the other two corners of the chip 14 are also depicted in FIG. 7. By means of these eight link members, power is distributed from the inner corners of the aforedescribed capacitor element 20 to the four corners of the chip 14. And, by means of the depicted signal leads and the power supply terminal members 38 and 39, the packaged chip can be physically secured and electrically connected to a standard mounting board, in a manner well known in the art.

Finally, it is to be understood that the above-described structure is only illustrative of the principles of the present invention. In accordance with these principles, numerous modifications and alternatives may be devised by those skilled in the art without departing from the spirit and scope of the invention. For example, although primary emphasis herein has been directed to a package that includes as an integral part thereof a frame-like capacitor element, it is to be understood, as stated earlier above, that in some embodiments of this invention the frame-like member is not fabricated to be a capacitor but designed instead simply to be a part of the housing for the associated chip. In those embodiments also, planar power and ground members, suitably insulated from each other, are formed on and within portions of the frame-like members so as to minimize power-ground loop inductance. In such an embodiment, the ground member could be a top planar portion such as the member 40 of FIG. 1, and the power member could be another planar portion within the frame 20 below the member 40. Suitable electrical connections from the power member to the lead-frame level of the package are made by vias and/or surface conductive patterns, in a standard manner known in the art.

## Claims

1. A semiconductor package comprising a semi-conductor chip (14) with conductive pads thereon, a body member (20) defining an interior cavity, means for mounting the chip within the cavity, multiple signal paths (21—33) having inner ends connected to respective ones of the pads on the chip and having outer ends that serve as signal terminal members, and the body member comprising spaced planar power members (40, 51) in parallel planes, characterised in that said planar members have outer peripheral portions (48) on external walls of the body member, and inner peripheral portions (54) on internal walls of the body member, the package comprising multiple link means (34, 35) connecting the inner peripheral portions of the planar members to selected ones of the pads on the chip, and a pair of power supply terminals members (38, 39) connected to the outer peripheral portions of respective ones of the power members.

2. A semiconductor package in accordance with claim 1, characterised in that an insulating layer (42) is formed on a selected part of one power member (40), and in that a portion of each signal pad extends over said insulating layer.

3. A semiconductor package in accordance with claim 1 or 2 characterised in that the body member comprises a capacitor element and the planar power members constitute the terminals and plates of the element.

4. A semiconductor package in accordance with claim 3, characterised in that the capacitor element comprises a frame-shaped multi-layer metallized ceramic capacitor.

5. A semiconductor package in accordance with claim 3 or 4, characterised in that the link means, the power supply members, and the signal paths constitute parts of an integral lead-frame assembly, and the link means and the inner ends of the signal paths are connected to pads on the chip in a tape-automated-bonding operation before the chip is mounted in the cavity.

## Patentansprüche

1. Halbleiterbauteilgehäuse mit einem Halbleiterchip (14), auf dem leitende Flecken angeordnet sind, mit einem Hauptkörper (20), der einen inneren Hohlraum definiert, mit einer Einrichtung zur Befestigung des Halbleiterchips in dem Hohlraum, mit einer Vielzahl von Signalwegen (21—33), deren inneres Ende mit jeweils einem der leitenden Flecken auf dem Chip verbunden ist und deren äußeres Ende als Signalanschluß dient, wobei der Hauptkörper im Abstand angeordnete, ebene Stromzuführungsteile (40, 51) in parallelen Ebenen aufweist, dadurch gekennzeichnet, daß die ebenen Stromzuführungsteile periphere äußere Abschnitte (48) auf Außenwänden des Hauptkörpers und periphere innere Abschnitte (54) auf Innenwänden des Hauptkörpers besitzen und daß das Gehäuse eine Vielzahl von Verbindungsgliedfern (34, 35) aufweist, die die peripheren inneren Abschnitte der ebenen Stromzuführungsteile mit gewählten Flecken auf dem Chip verbinden, sowie ein Paar von Stromzuführungsanschlüssen (38, 39), die mit den peripheren äußeren Abschnitten entsprechender Stromzuführungsteile verbunden sind.

2. Halbleiterbauteilgehäuse nach Anspruch 1, dadurch gekennzeichnet, daß eine Isolierschicht (42) auf einem gewählten Abschnitt eines Stromzuführungsteils (40) gebildet ist und daß ein Teil jedes Signalweges sich über die Isolierschicht erstreckt.

2. Halbleiterbauteilgehäuse nach Anspruch 1 oder 2, dadurch gekennzeichnet, daß der Hauptkörper ein Kondensatorbauteil aufweist und daß die ebenen Stromzuführungsteile die Anschlüsse und Belegungen des Bauteils darstellen.

4. Halbleiterbauteilgehäuse nach Anspruch 3, dadurch gekennzeichnet, daß das Kondensatorbauteil ein rahmen-förmiger Keramikkondensator mit einer Vielzahl metallisierter Schichten ist.

5. Halbleiterbauteilgehäuse nach Anspruch 3 oder 4, dadurch gekennzeichnet, daß die Verbindungsglieder, die Stromzuführungsteile und die Signalwege Teile einer einstückigen Leiter-Rahmenanordnung darstellen und daß die Verbindungsglieder und das innere Ende der Signalwege mit Flecken auf dem Chip in einem automatischen Bond-Vorgang verbunden werden, bevor der Chip in dem Hohlraum befestigt wird.

**Revendications**

1. Un boîtier pour semiconducteur comprenant une puce de semiconducteur (14) qui porte des plots conducteurs, un corps (20) définissant une cavité intérieure, des moyens pour monter la puce à l'intérieur de la cavité, plusieurs chemins de signal (21—33) ayant des extrémités intérieures qui sont connectées à des plots respectifs sur la puce, et ayant des extrémités extérieures qui remplissent la fonction de bornes de signal, et le corps comprenant des éléments d'alimentation plans et espacés (40, 51) dans des plans parallèles, caractérisé, en ce que ces éléments plans ont des parties périphériques extérieures (48) sur des parois externes du corps, et des parties périphériques intérieures (54) sur des parois internes du corps, le boîtier comprenant des éléments de liaison multiples (34, 35) qui connectent les parties périphériques intérieures des éléments plans à des plots sélectionnés parmi les plots formés sur la puce, et une paire de bornes d'alimentation (38, 39) qui sont connectées aux parties périphériques extérieures d'éléments respectifs parmi les éléments d'alimentation.

2. Un boîtier pour semiconducteur selon la revendication 1, caractérisé en ce qu'une couche isolante (42) est formée sur une partie sélectionnée d'un élément d'alimentation (40), et en ce qu'une partie de chaque chemin de signal s'étend sur cette couche isolante.

3. Un boîtier pour semiconducteur selon la revendication 1 ou 2, caractérisé en ce que le corps comprend un condensateur et les éléments d'alimentation plans constituent les bornes et les armatures de ce condensateur.

4. Un boîtier pour semiconducteur selon la revendication 3, caractérisé en ce que le condensateur consiste en un condensateur à céramique métallisée multicouche en forme de cadre.

5. Un boîtier pour semiconducteur selon la revendication 3 ou 4, caractérisé en ce que les moyens de liaison, les éléments d'alimentation et les chemins de signal constituent des parties d'une structure de cadre de montage en une seule pièce, et les moyens de liaison et les extrémités intérieures des chemins de signal sont connectés à des plots sur la puce au cours d'une opération de fixation automatisée de puces montées sur bande, avant que la puce soit montée dans la cavité.

EP 0 077 818 B1

*FIG. 1*

*FIG. 2*

*FIG. 3*

FIG. 4

FIG. 5

2

FIG. 6

FIG. 7

3